Europäisches Patentamt

European Patent Office

Office européen des brevets

(11) Numéro de publication: **0 319 425**
**A1**

(12) **DEMANDE DE BREVET EUROPEEN**

(21) Numéro de dépôt: 88403045.3

(22) Date de dépôt: 02.12.88

(51) Int. Cl.⁴: **H 01 L 23/38**
H 01 L 23/50, G 06 K 19/06

(30) Priorité: 03.12.87 FR 8716742

(43) Date de publication de la demande:
07.06.89 Bulletin 89/23

(84) Etats contractants désignés: **DE ES GB IT NL**

(71) Demandeur: **SGS-THOMSON MICROELECTRONICS S.A.**
**7, Avenue Galliéni**
**F-94250 Gentilly (FR)**

(72) Inventeur: **Brisson, Pierre**
**CABINET BALLOT-SCHMIT 84, Avenue Kléber**
**F-75116 Paris (FR)**

**Gloton, Jean-Pierre**
**CABINET BALLOT-SCHMIT 84, Avenue Kléber**
**F-75116 Paris (FR)**

(74) Mandataire: **Ballot, Paul Denis Jacques et al**
**Cabinet Ballot-Schmit 84, avenue Kléber**
**F-75116 Paris (FR)**

(54) Carte à puce munie d'un circuit intégré électronique et soumise à une contrainte mécanique ou électrique.

(57) Pour résister à des contraintes mécaniques, thermiques, électrostatiques, et d'utilisation à cadences élevées, on adjoint à un circuit (3) intégré électronique une cellule (18, 20) à effet Peltier. Par le gradient de température que cette cellule confère dans les endroits (16) critiques de ce circuit intégré thermiquement (21) en contact avec elle, on résout les problèmes entraînés par ces contraintes. On régule le fonctionnement de cette cellule en fonction de la mesure de ces contraintes. On évite ainsi une trop grande consommation de courant.

EP 0 319 425 A1

**Description**

# CARTE A PUCE MUNIE D'UN CIRCUIT INTEGRE ELECTRONIQUE ET SOUMISE A UNE CONTRAINTE MECANIQUE OU ELECTRIQUE

La présente invention a pour objet une carte à puce munie d'un circuit intégré électronique et soumise à une contrainte. Cette contrainte peut trouver son origine dans le circuit intégré lui-même ou provenir des conditions d'utilisation mécaniques, ou électriques de ce circuit. Elle trouve son application plus particulièrement dans les circuits électroniques dont le temps de réponse électrique doit être le plus faible possible.

On connaît les circuits intégrés électroniques, notamment ceux comportant un micro- processeur en relation avec une mémoire. L'utili- sation de ces circuits intégrés électroniques se généralise, notamment par l'usage des cartes électroniques, dites aussi cartes à puce, où l'organe d'interaction entre un usager et un service est constitué par une telle carte. Cette carte peut permettre de gérer l'identification du porteur, son autorisation d'accès, ou son crédit. Elle peut encore permettre la constitution d'une banque de données relatives à ce porteur. Les contraintes auxquelles peuvent être soumises les cartes sont de diverses natures. Elles peuvent être mécaniques quand la carte qui maintient le circuit intégré est souple et qu'elle est soumise à des déformations, ces déformations entraînant des déformations du composant électronique qu'elle contient. Elles peuvent être électrostatiques lors de la manipulation du circuit intégré : lors de son installation sur son support ou lors des frottements qui résultent de l'insertion de la carte électronique dans un lecteur. Enfin, les contraintes d'utilisation du circuit intégré peuvent consister en un rythme d'injection de signaux électriques supérieur au rythme maximum admissible par ce circuit intégré compte tenu de sa technologie de fabrication.

Dans l'état de la technique, il est connu de remédier à certains de ces inconvénients en agissant de telle sorte que le circuit intégré électronique ne soit pas directement sollicité par la contrainte néfaste. S'agissant de l'aspect mécanique il est connu de renforcer les boîtiers de maintien. S'agissant des décharges électrostatiques il est connu de le doter de disjoncteurs intégrés à même le circuit, ou extérieurs. Les disjoncteurs sont principalement constitués par des jonctions électroniques de claquage dont la tension de seuil est fixée en dessous du seuil de détérioration de ce circuit intégré. S'agissant du rythme, ou bien on ne fait rien et les tolérances d'utilisation du circuit s'en ressentent, ou bien on lui adjoint des mémoires tampons susceptibles d'accepter des signaux à grande cadence. Les mémoires peuvent permettent de faire travailler le circuit intégré en temps différé. Dans ce cas on n'obtient pas, bien entendu, un vrai fonction- nement en temps réel.

L'invention a pour objet de remédier à ces inconvénients en proposant une solution dans laquelle le circuit intégré comporte, intégré dans le circuit. un composant actif de réaction à la contrainte. Dans un exemple le composant actif de réaction à la contrainte est une cellule à effet Peltier. Cette cellule permet, en regard de l'endroit où elle est placée dans le circuit intégré, de créer un refroidissement localisé et donc un gradient de température. Lorsque cette cellule est en fonction- nement, le circuit intégré se prémunit d'une manière active contre les contraintes décrites d'autre part. En effet, comme il fonctionne dans les zones concernées à plus basse température il est susceptible d'accepter un rythme plus élevé. De même l'abaissement de température de ces zones en regard déplace vers les valeurs élevées les tensions de claquage des jonctions utiles de ce circuit. En conséquence, l'effet des décharges électrostatiques est amoindri. Enfin, le refroidissement provoque un durcissement correspondant de la structure ce qui la rend plus résistante, à taille égale, que dans l'état de la technique cité.

L'invention a donc pour objet un circuit intégré électronique soumis à une contrainte, caractérisé en ce qu'il comporte des moyens actifs de réaction à cette contrainte.

L'invention sera mieux comprise à la lecture de la description qui suit et à l'examen de la figure qui l'accompagne. Celles-ci ne sont données qu'à titre indicatif et nullement limitatif de l'invention.

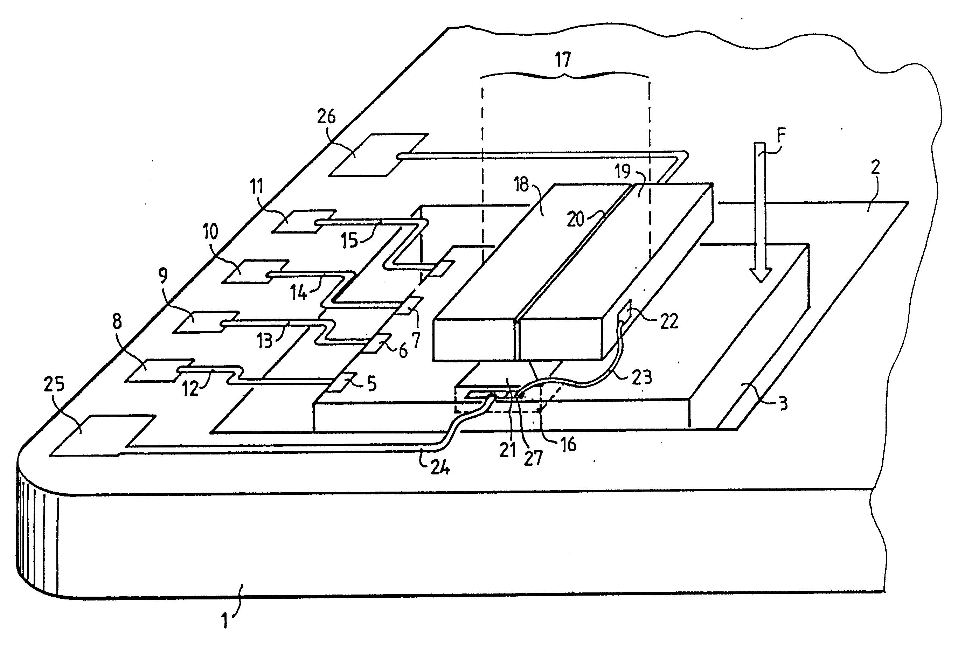

La figure 1 unique montre un exemple d'un circuit intégré électronique muni d'un composant actif selon l'invention.

Dans cette figure une carte 1, dite électronique ou à puce, contient une cavité 2 destinée à recevoir un circuit intégré électronique 3. Le circuit intégré électronique est descendu dans la cavité 2 selon la flèche F et ses connexions fonctionnelles 5 à 7 sont ensuite classiquement reliées à des métallisations 8 à 11 par des fils de liaison tels que 12 à 15. Les métallisations 8 à 11 apparaissent en surface de la carte 1 et permettent, dans l'exemple décrit, d'utiliser le circuit 3.

Ce qui caractérise l'invention est la présence, en regard d'une zone 16 critique du circuit intégré 3, d'un composant actif : une cellule Peltier 17. Cette cellule est constituée de deux blocs métalliques respectivement 18 et 19, reliés par une soudure 20. L'effet Peltier résulte d'un dégagement ou d'une absorption de chaleur à l'endroit de la soudure 20 selon le sens du passage du courant, par exemple du bloc métallique 18 vers le bloc métallique 19 ou en sens inverse. A l'endroit de la soudure, une différence de potentiel de contact $v$ s'oppose ou respectivement au contraire favorise le passage de charges électroniques $q$ selon le sens du courant. L'effet Peltier a pour conséquence que le travail W nécessaire pour faire franchir la soudure 20 aux charges $q$ est tel que :

$$W = v.q$$

quand W est négatif et correspond à une absorption de chaleur Q, celle-ci est proportionnelle à la quantité de charges $q$ transférée (et donc à l'intensité du courant qui franchit la soudure).

D'autre part cette absorption dépend de la température et de la nature des métaux constituant les blocs 18 et 19. Quand le courant passe dans un sens, il y a dégagement de chaleur à l'endroit de la soudure 20 , quand il passe dans un autre sens il y a absorption de chaleur. On remarque cependant que le bilan thermique de l'ensemble comprend aussi le dégagement de chaleur par effet joule dans les conducteurs d'alimentation des blocs et dans les blocs eux-mêmes d'une part, et l'absorption de chaleur à l'endroit de la soudure 20 d'autre part.

Dans l'invention on profite de l'effet de gradient ainsi provoqué. Par l'intermédiaire d'un socle de transfert thermique 21, et en choisissant convenablement le sens du courant, on prélève des calories dans la zone 16 du circuit intégré, on les dirige sur la soudure 20. A cette fin le socle est de section appropriée, ici elle est trapezoîdale. Cette soudure 20 les évacue les calories de part et d'autre dans les blocs métalliques 18 et 19. Ces blocs métalliques 18 et 19 ne sont cependant pas qu'un gros radiateur, concentrant son effet sur la région 16, mais agissent en outre comme un réfrigérateur. En effet du fait du fonctionnement de la cellule Peltier, la zone 16 se trouve portée à une température inférieure à celle à laquelle se trouvent portés les blocs métalliques 18 et 19 eux-mêmes.

Dans l'état de la technique, quand des radiateurs sont utilisés, du fait de la convection, la zone à refroidir 16 est toujours portée à une température plus élevée que celle de son radiateur (sinon la convection ne se produit pas ou au contraire se produit même à l'envers).

Pour faire passer du courant dans la cellule Peltier on peut utiliser des liaisons spécialisées reliées à une alimentation électrique. Par exemple une borne 22 de connexion de la cellule 17 est reliée par l'intermédiaire de fils de liaison 23-24 à une métallisation 25 de contact destinée à recevoir une des bornes de l'alimentation électrique. Une autre métallisation 26 est destinée à recevoir l'autre borne de cette alimentation. L'alimentation électrique de la cellule peut ainsi être permanente.

Cependant, dans les circuits intégrés existants, la définition d'une borne supplémentaire de connexion peut s'avérer rédhibitoire. Dans ce cas on peut prélever dans le circuit intégré lui-même, en une prise 27 au moins une des tensions nécessaires. L'autre tension peut aussi être prélevée avec une prise (non visible). Cette prise de tension 27 est alors reliée par la liaison 23 à la borne 22 de la cellule 17. Sur la figure la prise 27 qui comporte une métallisation peut même servir de relais de raccordement à la liaison 24 dans le cas où on accepte d'équiper le circuit intégré avec une sortie supplémentaire. Ceci confère un caractère amovible à la cellule 17.

Comme la cellule à effet Peltier consomme du courant, il peut se justifier de ne pas en maintenir l'alimentation en permanence. Dans ce cas on utilisera pluôtt les prises l'alimentation telles que 27 pour multiplexer, avec l'alimentation générale du circuit, l'alimentation de la cellule 19. D'une manière préférée la commande de multiplexage ou plus généralement la commande d'alimentation de la cellule sera même une commande résultant d'une régulation, par exemple en température, des contraintes auxquelles est soumis le circuit intégré. Par exemple, dès que le circuit s'échauffe au-delà d'un seuil prédéterminé, la cellule Peltier est mise en marche ; dès que la température thermostatée est atteinte la cellule Peltier est arrêtée. Ce mode de fonction- nement permet d'éviter une consommation trop importante de courant, notamment dans des applications de type portatif ou spatial. La mesure de la contrainte, dans l'exemple de la température, dans la région 16 critique du circuit intégré peut être obtenue de manière classique. La mise en conduction de la prise 27 avec l'alimentation générale du circuit est autorisée en conséquence par la réalisation des circuits correspondant à la portée de l'homme du métier.

## Revendications

1 - Carte à puce munie d'un circuit (3) intégré électronique, soumise à une contrainte, mécanique ou électrique caractérisée en ce qu'elle comporte des moyens (18, 20) actifs de réaction à cette contrainte.

2 - Carte selon la revendication 1 caractérisé en ce que les moyens actifs comportent un radiateur de refroidissement comportant une cellule à effet Peltier.

3 - Carte selon la revendication 2 caractérisé en ce que la cellule comporte un conducteur formé de deux métaux (18, 19) en contact par une soudure (20), cette soudure étant thermiquement au contact d'un socle (21) de transfert thermique, ce socle étant thermiquement au contact (16) d'une partie du circuit intégré.

4 - Carte selon l'une quelconque des revendications 2 ou 3, caractérisé en ce qu'il comporte des moyens (27) pour multiplexer l'alimentation de la cellule avec l'alimentation générale du circuit.

5 - Carte selon la revendication 4 caractérisé en ce que la commande de multiplexage est régulée en fonction d'une température à atteindre.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | GB-A-2 112 565 (FERRANTI) * Revendications 1,7 * --- | 1,2 | H 01 L 23/38 H 01 L 23/50 G 06 K 19/06 |
| A | EP-A-0 198 376 (EM MICROELECTRONIC-MARIN) --- | | |
| A | PATENT ABSTRACTS OF JAPAN, vol. 11, no. 104 (E-494)[2551], 2 avril 1987, page 145 E 494; & JP-A-61 253 842 (NEC CORP.) 11-11-1986 ----- | | |

DOMAINES TECHNIQUES RECHERCHES (Int. Cl.4)

H 01 L
G 06 K

Le présent rapport a été établi pour toutes les revendications

| Lieu de la recherche | Date d'achèvement de la recherche | Examinateur |
|---|---|---|
| LA HAYE | 08-03-1989 | DE RAEVE R.A.L. |